# FASCICULE DE BREVET EUROPEEN

(11) **EP 0 488 894 B1**
(45) Date de publication et mention de la délivrance du brevet: **11.06.1997**
(21) Numéro de dépôt: 91403220.6
(22) Date de dépôt: 27.11.1991
(51) Int. Cl.: H01R 23/66, H01R 9/07

(54) **Système de connexion pour équipement amovible**
Verbindungssystem für abnehmbare Einrichtung
Connection system for removable device

(30) Priorité: 30.11.1990 FR 9015056
(43) Date de publication de la demande: 03.06.1992
(73) Titulaire: BULL S.A., 92800 Puteaux (FR)
(72) Inventeur: Cesar, Charles, F-75116 Paris (FR)
(74) Mandataire: Debay, Yves

(56) Documents cités:
- FR-A- 2 283 528
- US-A- 3 120 415
- US-A- 3 325 769
- US-A- 4 533 188

## Description

La présente invention concerne un système pour la connexion d'un équipement amovible dans un logement d'une baie de réception d'une pluralité d'équipements électriques, comportant des premiers moyens de connexion pour relier électriquement l'équipement amovible à la baie de réception, des seconds moyens de connexion, internes à l'équipement amovible, reliés aux premiers moyens de connexion par l'intermédiaire de moyens de liaison électrique.

Il est courant de rencontrer des combinaisons de modules électroniques amovibles connectés dans des baies de réception, chaque module pouvant, indépendamment des autres modules, être introduit et ainsi connecté électriquement ou extrait et donc déconnecté électriquement de son logement dans la baie. Ainsi en est-il des baies de réception d'ordinateur pouvant contenir, par exemple, l'unité centrale et différents équipements périphériques. Plus particulièrement avec un certain nombre d'applications sont apparues de nouvelles exigences concernant l'interchangeabilité des différents modules. Il faut pouvoir rapidement et aisément, d'une part remplacer un module ou équipement périphérique en panne, et d'autre part substituer un module ou équipement périphérique à un autre. Une telle option suppose une standardisation des modules en ce qui concerne leur volume mais également leur système de connexion, ce qui inévitablement entraîne des problèmes mécaniques difficiles à résoudre.

Des systèmes de connexion répondant à ce type d'exigences sont connus de l'homme de métier. De tels systèmes nécessairement comportent tout d'abord des premiers moyens de connexion pour relier électriquement l'équipement amovible à la baie de réception, par exemple, un connecteur standard du commerce choisi pour cette application spécifique et qui, d'une part par sa position sur l'équipement permet la substitution d'équipements parmi une famille désirée (unités de disque dur, de disquette, de dérouleur de bande, par exemple) et d'autre part par le choix des contacts actifs utilisés autorise sélectivement l'alimentation et l'échange des données pour un et un seul équipement parmi la famille désirée. Ces systèmes de connexion comportent de plus des seconds moyens de connexion, internes à l'équipement amovible, reliés aux premiers moyens de connexion par l'intermédiaire de moyens de liaison électrique. Ces seconds moyens de connexion peuvent être des connecteurs standards enfichés sur des connecteurs du genre opposé présents dans l'équipement amovible (par exemple, reconnaissance d'une adresse, raccordement à un bloc d'alimentation, transmission de données, etc..), des fourchettes insérées dans des contacts à vis ou tout autre moyen de connexion. Enfin, les moyens de liaison peuvent être réalisés à partir de circuits imprimés pour des liaisons rigides, de fils conducteurs ou d'une combinaison de circuits imprimés et de fils conducteurs pour des liaisons nécessitant une certaine flexibilité.

Ce système selon l'art antérieur présente cependant divers inconvénients. En effet, de nos jours, il est à constater une forte tendance à la miniaturisation des équipements qui, en outre, sont de plus en plus sophistiqués et donc comportent un plus grand nombre de circuits et de composants. Une telle conjonction, miniaturisation du contenant et augmentation de la densité du contenu, ne permet de réserver qu'un volume extrêmement faible pour loger les moyens de liaison intermédiaires aux premiers et seconds moyens de connexion, ce qui interdit l'utilisation de moyens de liaison épais tels que les circuits imprimés ou les fils de l'art antérieur.

Le document US-A3.120415 décrit un système de connexion dont les moyens de liaison électrique sont constitués d'un circuit imprimé souple comportant des découpes longitudinales courtes, chaque découpe se terminant par un évidement circulaire à au moins l'une de ses extrémités.

En outre, dans le type d'application précédemment décrit, l'équipement amovible doit être prévu pour être connecté et déconnecté un très grand nombre de fois (de l'ordre de 10.000), tout en conservant des contacts électriques de grande qualité, ce qui ne peut être obtenu avec les connecteurs standards du commerce choisis car normalisés pour ladite application, ces connecteurs étant équipés de contacts standards. Ce problème connu de longue date n'a toujours pas reçu de solution rationnelle.

Un autre système de connexion électrique est connu du document US-A-3.325.769. Ses moyens de liaison électrique comportent également des découpes longitudinales.

La présente invention propose un système du genre précité mais qui ne présente pas les divers inconvénients du système connu.

Un tel système est défini dans la revendication 1.

Ainsi, un circuit imprimé souple choisi comme moyen de liaison, de par sa très faible épaisseur et sa grande souplesse peut s'insinuer dans des volumes ou espaces excessivement restreints. Il est également avantageux de l'utiliser pour la réalisation de liaisons très courtes. En outre, les découpes longitudinales pratiquées dans le circuit lui permettent de présenter une remarquable flexibilité autorisant des déviations importantes lorsque les connecteurs ou moyens de connexion présents dans l'équipement amovible sont disposés à divers emplacements d'accès souvent difficile, une déviation même importante d'une partie du circuit étant permise sans risque de déchirement du fait de la présence des évidements circulaires terminant les découpes. Enfin, le choix de contacts et de connexions autorisant un grand nombre de manoeuvres (de l'ordre de 10.000) sans dégradation de la liaison électrique permet de réaliser un progrès considérable.

Dans un mode de réalisation préféré et pour une utilisation intensive du système selon l'invention d'une part l'extrémité du circuit imprimé souple destinée à être reliée aux premiers moyens de connexion est, transversalement et au moins sur une de ses deux faces, revêtue d'une bande étroite d'un matériau rigide munie de trous métallisés calibrés superposés aux pastilles de connexion des lignes conductrices du circuit imprimé souple, et d'autre part les premiers moyens de connexion sont constitués d'un connecteur normalisé dont les contacts de connexion à la baie de réception sont lubrifiés et les connexions avec le circuit imprimé souple sont des connexions insérées en force dans les trous calibrés enserrant les pastilles du circuit imprimé souple.

L'idée consiste à utiliser un connecteur standard dont les contacts standards sont lubrifiés. Cette technique de lubrification des contacts permet en effet de diminuer très sensiblement la force d'insertion lors de l'accouplement de deux connecteurs. Ainsi il est permis de conserver les contacts standards normalisés pour la connexion à la baie de réception. Cependant, la solution à ce premier problème ne fait apparaître un second car les connexions assurant la liaison entre lesdits contacts et le circuit imprimé souple sont destinées à être soudées et de préférence, pour une meilleure industrialisation, à être soudées à la vague, or ce type de lubrifiants s'altère à une température de l'ordre de 80°C, température largement dépassée dans toute opération de soudage et en particulier de soudure à la vague pour laquelle la température est de l'ordre de 240°C. L'emploi de connexions à insérer en force permet de résoudre ce second problème, mais en fait naître un troisième. En effet, ce type de connexion ne peut, par définition, être inséré en force et donc se déformer pour constituer une liaison électrique dite étanche, que dans des parties rigides et par conséquent ne peut être utilisé avec un circuit imprimé souple.

Ce troisième problème est résolu en recouvrant la partie destinée à être reliée au connecteur, c'est-à-dire l'extrémité du circuit imprimé souple, sur au moins une de ces deux faces d'un matériau rigide tel que du verre époxy. Les connexions sont alors insérées en force dans les trous métallisés calibrés de l'ensemble circuit imprimé souple et matériau rigide constituant deux ou trois couches superposées [par exemple : verre époxy, circuit imprimé souple, (verre époxy)].

Dans un autre mode de réalisation et une utilisation intensive du système selon l'invention, les premiers moyens de connexion sont constitués d'un connecteur normalisé dont les contacts sont des contacts à piston et les connexions avec le circuit imprimé souple sont des connexions soudées sur les pastilles du circuit imprimé souple.

L'idée consiste également à utiliser un connecteur standard mais équipé avec des connexions standards à souder (de préférence soudure à la vague, le circuit imprimé souple étant en Kapton, matériau mécaniquement stable à 240°C) et des contacts à piston maintenus en pression au moyen de ressorts de raideur déterminée contenus dans lesdits contacts.

Une combinaison de ces modes de réalisation peut être, entre autres, obtenue. Pour cela, le système conforme à l'invention est remarquable en ce que, d'une part l'extrémité du circuit imprimé souple destinée à être reliée aux premiers moyens de connexion est, transversalement et au moins sur une de ses deux faces, revêtue d'une bande étroite d'un matériau rigide munie de trous métallisés calibrés superposés aux pastilles de connexion des lignes conductrices du circuit imprimé souple, et d'autre part les premiers moyens de connexion sont constitués d'un connecteur standard dont les contacts sont des contacts à piston et les connexions avec le circuit souple sont des connexions insérées en force dans les trous calibrés enserrant les pastilles du circuit imprimé souple.

Suivant une caractéristique remarquable du système de connexion selon l'invention, le circuit imprimé souple est muni de moyens de découplage améliorés des lignes conductrices affectées à la transmission des signaux, lesdites lignes affectées à la transmission des signaux étant bordées de doubles lignes conductrices reliées électriquement à la masse.

En effet, l'utilisation d'un circuit imprimé souple est avantageuse car pour un connecteur donné et donc un nombre de contacts donné, il est possible de connecter un plus grand nombre de lignes conductrices en doublant, voire en triplant si nécessaire, le nombre de celles-ci sans pour autant rencontrer des problèmes relatifs aux difficultés de souder ou sertir deux, voire trois, fils sur une même connexion. En particulier, à partir d'une pastille de connexion, deux lignes de masse qui sont tracées en parallèle permettent de border avantageusement et de manière spécifique chacune un côté de deux lignes de transmission de signaux situées de part et d'autre des lignes de masse. De cette manière, en disposant ainsi et de chaque côté d'une ligne de signal deux lignes de masse tirées du même point de connexion, il est obtenu un découplage nettement amélioré qui permet de réduire très sensiblement les phénomènes parasites dus aux commutations (des signaux binaires par exemple) et les phénomènes de diaphonie.

Selon une autre caractéristique remarquable du présent système utilisé dans une application de puissance, à une extrémité du circuit imprimé souple, des fourchettes de raccordement terminant des lignes conductrices constituent des seconds moyens de connexion, lesdites fourchettes de raccordement étant obtenues par pliage du circuit à l'intérieur d'une zone non isolée, suivant un axe passant par les centres de trous oblongs ménagés dans lesdites lignes conductrices de largeur appropriée.

De plus de manière avantageuse, pour faciliter le pliage lors de la mise en forme du circuit, il peut être prévu une réduction d'épaisseur des lignes conductrices suivant l'axe passant par les centres des trous oblongs.

Ainsi de manière simple, il est possible de réaliser directement, lors de l'élaboration du circuit imprimé souple, des fourchettes de raccordement, par exemple prévues pour la liaison de puissance à un bloc d'alimentation. Les trous oblongs peuvent être soit découpés ou percés dans le circuit, soit prévus lors de la sérigraphie. Dans le cas d'une liaison de puissance, les lignes conductrices sont, de manière générale, suffisamment larges pour que les trous y soient directement pratiqués. Pour d'autres applications, il faut prévoir, lors de la sérigraphie, un élargissement de la ligne sur une longueur légèrement supérieure à la longueur de la zone non isolée. Enfin, la réduction de l'épaisseur des lignes conductrices qui permet de réaliser un pliage précis et à l'endroit désiré peut être prévue également lors de la sérigraphie.

De manière remarquable dans le cas d'une application du présent système à une liaison de puissance, le courant de forte intensité passant dans les lignes conductrices est réparti sur une pluralité des contacts et connexions du connecteur standard des premiers moyens de connexion. En effet, connaissant la valeur de l'intensité qui peut être supportée par un contact, il est possible de répartir l'intensité totale sur plusieurs contacts et ceci que le courant passe par un seul conducteur de largeur appropriée ou par plusieurs conducteurs de plus faible largeur disposés en parallèle.

Le système selon l'invention peut également comporter avantageusement des moyens de blindage obtenus par pliage d'une nappe conductrice reliée à la masse et isolée prolongeant une extrémité du circuit imprimé souple. Un blindage adapté peut être ainsi aisément réalisé sans pour autant augmenter l'épaisseur du circuit imprimé souple, ledit blindage étant par exemple replié sous une partie du circuit alors qu'un adhésif ou tout autre moyen équivalent peut être prévu pour maintenir le blindage contre le circuit.

De plus, le fait d'utiliser un circuit imprimé souple est avantageux en ce que, pour réaliser des liaisons en divers emplacements distants et/ou avec des moyens de connexion différents au moins une bande indépendante peut être obtenue par découpe dudit circuit.

Enfin, divers composants électroniques peuvent être également supportés par le circuit imprimé souple. Ainsi, des moyens de découplage (capacités par exemple) ou de visualisation (diodes électroluminescentes par exemple) peuvent être soudés sur le circuit dans des volumes restreints et à divers emplacements souhaités. En particulier, une bande du circuit peut constituer le support d'un moyen de visualisation ; par exemple, cette bande peut être ramenée près d'une ouverture de la face avant de l'équipement amovible dans le but de fournir des informations relatives à l'état dudit équipement.

La description suivante, en regard des dessins annexés, le tout donné à titre d'exemple non limitatif, fera bien comprendre comment l'invention peut être réalisée.

La figure 1 représente, de manière schématique, une perspective d'un exemple de réalisation d'un système de connexion conforme à l'invention.

La figure 2 présente un exemple de réalisation d'un circuit imprimé souple qui peut être utilisé dans le système de connexion selon l'invention.

La figure 3 propose un second exemple de réalisation d'un circuit imprimé souple qui peut être utilisé dans le système de connexion de la présente invention.

La figure 4 montre, de manière schématique, une perspective du système de connexion utilisant le circuit imprimé souple de la figure 3.

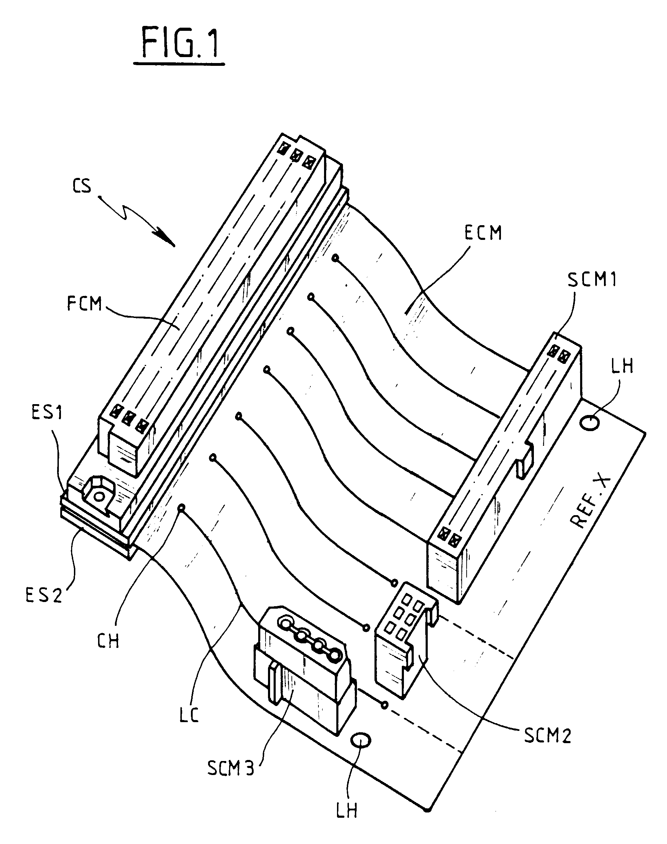

Sur la figure 1 est schématiquement représenté un système de connexion CS pour équipement amovible dans un logement d'une baie de réception d'une pluralité d'équipements électroniques. Ce système comporte des premiers moyens de connexion FCM pour relier électriquement l'équipement amovible à la baie de réception, des seconds moyens de connexion SCM₁, SCM₂, SCM₃, divers connecteurs normalisés internes à l'équipement amovible, reliés aux premiers moyens de connexion FCM par l'intermédiaire de moyens de liaison électrique ECM. Conformément à l'idée de l'invention, les moyens de liaison électriques ECM sont constitués d'un circuit imprimé souple, par exemple en kapton, comportant une pluralité de découpes longitudinales LC pratiquées sur la plus grande partie de sa longueur, chaque découpe se terminant par un évidement circulaire CH à au moins une de ses extrémités alors que les premiers moyens de connexion reliés à la baie de réception sont équipés de contacts et/ou de connexions spécialement prévus pour satisfaire à un grand nombre d'opérations de connexion et de déconnexion.

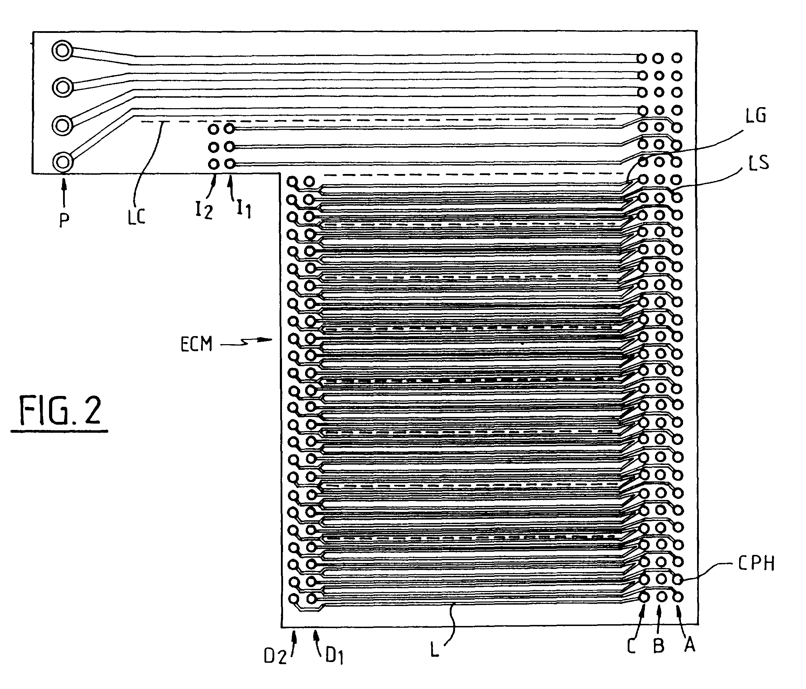

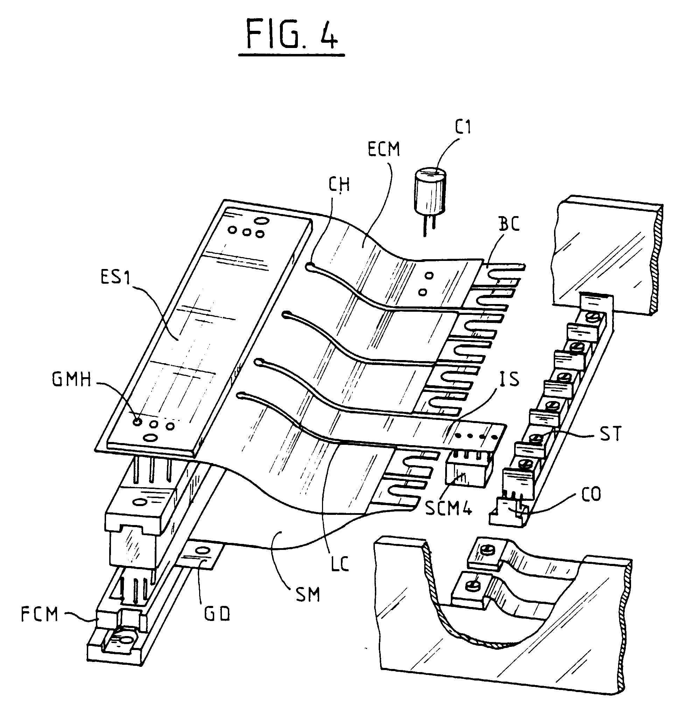

Dans un premier mode de réalisation tel que représenté sur la figure 1, l'extrémité du circuit imprimé souple ECM destinée à être reliée aux premiers moyens de connexion FCM est transversalement et sur ses deux faces revêtue de deux bandes étroites ES₁, ES₂ d'un matériau rigide, par exemple du verre époxy, munies de trous métallisés calibrés (visibles sur la figure 4 sous la référence GMH) superposés aux pastilles de connexion (voir figure 2, référence CPH) des lignes conductrices (figure 2, référence L) du circuit imprimé souple. Egalement dans ce premier mode de réalisation, les premiers moyens de connexion FCM sont constitués d'un des connecteurs standards par exemple du type DIN 41612 de chez AMP, HARTING, BURNDY ou autres constructeurs, dont les contacts de connexion à la baie de réception sont lubrifiés et les connexions avec le circuit imprimé souple sont des connexions, par exemple du type "Action pin contact" de chez AMP, insérées en force dans les trous calibrés GMH enserrant les pastilles CPH du circuit imprimé souple.

Selon une variante de réalisation, les premiers moyens de connexion FCM sont constitués d'un connecteur standard par exemple du type DIN 41612 forme "C" ou autre, dont les contacts sont des contacts à piston, par exemple du type P2664-2V de chez AUGAT, et les connexions avec le circuit imprimé souple sont des connexions du type S2664-1ET de chez AUGAT, soudées sur les pastilles CPH du circuit imprimé souple ECM. Pour faciliter l'industrialisation, les connexions sont soudées à la vague sur le circuit ECM ; il est alors prévu des trous de positionnement LH permettant de maintenir le circuit en position pendant cette opération de soudage.

Une troisième variante pourrait très bien consister en une combinaison des deux premières. En effet, au connecteur standard, par exemple de type DIN 41612 forme "C", équipé de contacts à piston du type P2664-2V, pourraient être associées des connexions insérées en force du type S2664-1PF, l'extrémité du circuit imprimé souple étant, dans ce cas, transversalement et au moins sur une de ses deux faces, revêtue d'une bande étroite d'un matériau rigide munie de trous métallisés calibrés superposés aux pastilles de connexion des lignes conductrices du circuit imprimé souple.

Sur la figure 2 est proposé un exemple de réalisation d'un circuit imprimé souple ECM qui peut être utilisé dans le système de connexion selon l'invention.

Le circuit ECM comporte des lignes conductrices L terminées par des pastilles de connexion CPH ainsi que des découpes longitudinales LC représentées en trait pointillé terminées par des évidements circulaires CH non représentées pour éviter de charger la figure.

De manière remarquable, le circuit ECM est muni de moyens de découplage améliorés des lignes conductrices affectées à la transmission des signaux, telles que sur la figure 2 les lignes L_{S} dont les origines sont les pastilles de connexion CPH de la colonne référencée A, lesdites lignes L_{S} étant bordées de doubles lignes conductrices reliées électriquement à la masse, comme sur la figure 2 les lignes L_{G} dont les origines sont les pastilles de connexion CPH de la colonne référencée C. Ainsi, la figure 2 montre que deux lignes de masse L_{G} tirées en parallèle d'une pastille de connexion de la colonne C permettent de border avantageusement et de manière spécifique chacune un côté de deux lignes de transmission de signaux L_{S} situées de part et d'autre des lignes L_{G}.

En outre, la figure 2 présente un exemple non limitatif de circuit ECM réalisant la liaison entre un connecteur FCM (figure 1) d'interface avec la baie de réception, raccordé aux rangées A, B, C des pastilles de connexion CPH, et trois connecteurs SCM₁, SCM₂, SCM₃, le connecteur SCM₁, utilisé par exemple pour la transmission de données, raccordé aux colonnes D₁ et D₂ des pastilles de connexion, le connecteur SCM₂, utilisé par exemple pour l'identification du périphérique, raccordé aux colonnes I₁ et I₂ des pastilles de connexion et le connecteur SCM₃, utilisé par exemple pour l'alimentation du périphérique et raccordé à la colonne P des pastilles de connexion.

Toute forme de circuit est, bien entendu, réalisable et les découpes LC procurent une grande flexibilité au circuit ECM autorisant des déviations selon les trois dimensions. De manière secondaire mais pratique une référence peut être avantageusement inscrite par sérigraphie sur le circuit ECM constituant un repère utile au montage et/ou au stockage (voir figure 1, "REF. X").

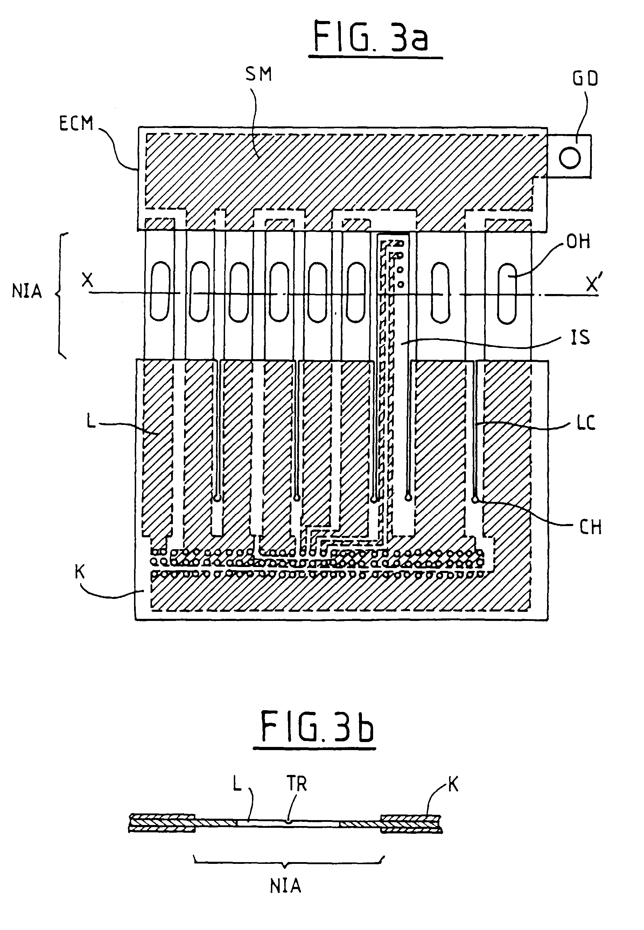

Sur les figures 3 et 4 est représenté un autre exemple de réalisation de circuit imprimé souple ECM qui peut être utilisé de préférence dans des applications, par exemple applications de puissance, pour lesquelles le raccordement est réalisé au moyen de fourchettes insérées dans des contacts à vis, tout en conservant un maximum de flexibilité grâce aux découpes LC terminées par les évidements circulaires CH.

Selon une caractéristique du système conforme à l'invention des fourchettes de raccordement BC (figure 4) terminant des lignes conductrices L (figure 3a) à une extrémité du circuit imprimé souple ECM constituent des seconds moyens de connexion. Ces fourchettes de raccordement BC sont obtenues par pliage du circuit à l'intérieur d'une zone non isolée NIA, suivant un axe XX' passant par les centres de trous oblongs OH ménagés dans les lignes conductrices L de largeur appropriée. Sur la figure 3a, les lignes conductrices L sont suffisamment larges pour que les trous OH y soient directement pratiqués. Bien entendu, une fourchette de raccordement peut être également obtenue à partir d'une ligne conductrice de plus faible largeur, il suffit dans ce cas de prévoir lors de l'élaboration du circuit ECM un élargissement de la ligne sur une longueur légèrement supérieure à celle de la zone non isolée. Sur la figure, les parties hachurées représentent le matériau conducteur lorsque celui-ci est recouvert d'isolant.

La figure 3b représente, avec un certain grossissement pour une meilleure lisibilité du dessin, une coupe longitudinale du circuit ECM opérée selon le plan médian d'une ligne conductrice aux environs de la zone non isolée NIA. Le conducteur L est apparent dans la zone NIA, c'est-à-dire non recouvert d'isolant K. Afin que la mise en forme du circuit lors du pliage soit facilitée et réalisée avec précision, il peut être prévu une réduction d'épaisseur TR des lignes conductrices L suivant l'axe XX' passant par les centres des trous oblongs OH.

La figure 4 montre les différentes fourchettes BC obtenues destinées à être insérées dans les contacts à vis ST présents dans l'équipement amovible.

Sur la figure 3a, les lignes conductrices L larges peuvent chacune être reliées au connecteur FCM par l'intermédiaire de plusieurs trous de connexion, ce qui permet de répartir l'intensité du courant, dans le cas d'une liaison de puissance par exemple, sur une pluralité de contacts et de connexions d'un connecteur standard.

De même, le système de connexion peut comporter des moyens de blindage obtenus par pliage d'une nappe conductrice SM reliée à la masse et isolée prolongeant une extrémité du circuit ECM. La nappe conductrice est reliée à la masse sur la figure 3a par l'intermédiaire de plusieurs conducteurs eux-mêmes reliés à la masse, et repliée sous le circuit pour créer un écran. Le circuit ECM peut également comporter une extension non isolée GD de la nappe conductrice percée d'un trou qui permet de la relier directement à la masse du châssis.

Dans l'exemple proposé à la figure 4, le circuit ECM est revêtu sur un seul de ses côtés d'une bande rigide ES₁, par exemple en verre epoxy.

Sur les figures 3 et 4 apparaît une bande indépendante IS obtenue par découpe du circuit ECM, la bande IS supportant un connecteur SCM₄ à raccorder à un connecteur CO du genre opposé situé dans l'équipement amovible. Tout type de découpe peut être pratiqué pour obtenir des bandes indépendantes, notamment pour séparer des connecteurs à raccorder à des emplacements distants ou à des niveaux différents. En particulier, une combinaison des circuits représentés aux figures 2 et 3 peut être ainsi avantageusement obtenue. En outre, sur la figure 1, des découpes LC peuvent être prolongées (représentation en traits pointillés) jusqu'à l'extrémité du circuit ECM pour former des bandes indépendantes.

Enfin, le circuit ECM peut supporter des composants C₁, par exemple des capacités pour le découplage aux bornes de l'alimentation et des diodes électroluminescentes pour la visualisation. Ainsi, une telle diode pourrait être soudée sur une bande indépendante découpée sur le circuit et ramenée à un emplacement désiré pour renseigner sur un état donné de l'équipement amovible. Il est à noter également que le circuit imprimé souple, de par sa conception, peut permettre de plus de réaliser de manière naturelle une fonction filtrage en réduisant les pointes de courant grâce aux capacités parasites qu'il engendre.

En conclusion, un tel système présente de nombreux avantages quant à son utilisation dans des équipements amovibles ne disposant que de faibles volumes internes pour l'y insérer.

La nature même du circuit imprimé souple autorise l'utilisation du système pour un grand nombre d'applications.

Enfin, des tests réalisés avec ce système ont permis de vérifier sa fiabilité et sa résistance, alors que ledit système était soumis à un grand nombre d'opérations de connexion et de déconnexion (supérieur à 10.000).

## Revendications

1. Système de connexion (CS) pour équipement amovible dans un logement d'une baie de réception d'une pluralité d'équipements électroniques, comportant des premiers moyens de connexion (FCM) pour relier électriquement l'équipement amovible à la baie de réception, des seconds moyens de connexion (SCM1, SCM2,...) internes à l'équipement amovible, reliés aux premiers moyens de connexion par l'intermédiaire de moyens de liaison électrique (ECM) constitués d'un circuit imprimé souple comportant une pluralité de découpes longitudinales (LC) qui s'étendent des premiers moyens de connexion (FCM) aux seconds moyens de connexion (SCM), chaque découpe se terminant par un évidement circulaire (CH) à au moins une de ses extrémités, les découpes longitudinales (LC) autorisant des déviations dudit circuit imprimé souple, les premiers moyens de connexion reliés à la baie de réception étant équipés de contacts à faible force d'insertion pour satisfaire à un grand nombre d'opérations de connexion et de déconnexion, lesdits contacts coopérant avec des connexions normalisées.

2. Système de connexion (CS) pour équipement amovible selon la revendication 1, caractérisé en ce que d'une part l'extrémité du circuit imprimé souple (ECM) destinée à être reliée aux premiers moyens de connexion est, transversalement et au moins sur une de ses deux faces, revêtue d'une bande étroite d'un matériau rigide (ES1,...) munie de trous métallisés calibrés (GMH) superposés aux pastilles de connexion (CPH) des lignes conductrices (L) du circuit imprimé souple (ECM), et d'autre part les premiers moyens de connexion (FCM) sont constitués d'un connecteur normalisé dont les contacts de connexion à la baie de réception sont lubrifiés et les connexions avec le circuit imprimé souple sont des connexions insérées en force dans les trous calibrés enserrant les pastilles (CPH) du circuit imprimé souple (ECM).

3. Système de connexion (CS) pour équipement amovible selon la revendication 1, caractérisé en ce que les premiers moyens de connexion (FCM) sont constitués d'un connecteur normalisé dont les contacts sont des contacts à piston et les connexions avec le circuit imprimé souple sont des connexions soudées sur les pastilles (CPH) du circuit imprimé souple (ECM).

4. Système de connexion (CS) pour équipement amovible selon la revendication 1, caractérisé en ce que d'une part l'extrémité du circuit imprimé souple destinée à être reliée aux premiers moyens de connexion (FCM) est, transversalement et au moins sur une de ses deux faces, revêtue d'une bande étroite d'un matériau rigide (ES1,...) munie de trous métallisés calibrés (GMH) superposés aux pastilles de connexion (CPH) des lignes conductrices (L) du circuit imprimé souple (ECM), et d'autre part les premiers moyens de connexion (FCM) sont constitués d'un connecteur normalisé dont les contacts sont des contacts à piston et les connexions avec le circuit souple sont des connexions insérées en force dans les trous calibrés GMH) enserrant les pastilles (CPH) du circuit imprimé souple (ECM).

5. Système de connexion (CS) pour équipement amovible selon la revendication 2, 3 ou 4, caractérisé en ce que le circuit imprimé souple (ECM) est muni de moyens de découplage des lignes conductrices affectées à la transmission des signaux, lesdites lignes (LS) affectées à la transmission des signaux étant bordées de doubles lignes (LG) conductrices reliées électriquement à la masse.

6. Système de connexion (CS) pour équipement amovible selon l'une des revendications précédentes, caractérisé en ce que à une extrémité du circuit imprimé souple des fourchettes de raccordement (BC) terminant des lignes conductrices (L) constituent des seconds moyens de connexion (SCM), lesdites fourchettes de raccordement (BC) étant obtenues par pliage du circuit à l'intérieur d'une zone non isolée (NIA), suivant un axe (XX') passant par les centres de trous oblongs (OH) ménagés dans lesdites lignes conductrices (L) de largeur appropriée.

7. Système de connexion (CS) pour équipement amovible selon la revendication 6, caractérisé en ce que, pour faciliter le pliage lors de la mise en forme du circuit, il est prévu une réduction d'épaisseur (TR) des lignes conductrices (L) suivant l'axe (XX') passant par les centres des trous oblongs (OH).

8. Système de connexion (CS) pour équipement amovible selon l'une des revendications précédentes, caractérisé en ce qu'il comporte des moyens de blindage obtenus par pliage d'une nappe conductrice (SM) reliée à la masse et isolée prolongeant une extrémité du circuit imprimé souple (ECM).

## Patentansprüche

1. Anschlußsystem (CS) für eine abnehmbare Einrichtung in einem Sitz eines Aufnahmegestells für mehrere elektronische Einrichtungen, mit ersten Anschlußmitteln (FCM), um die abnehmbare Einrichtung elektrisch mit dem Aufnahmegestell zu verbinden, mit zweiten Anschlußmitteln (SCM1, SCM2,...) im Inneren der abnehmbaren Einrichtung, die mit den ersten Anschlußmitteln über Mittel (ECM) zur elektrischen Verbindung verbunden sind, die aus einer biegsamen gedruckten Schaltung bestehen, die mehrere Längsausschnitte (LC) aufweist, die sich von den ersten Anschlußmitteln (FCM) zu den zweiten Anschlußmitteln (SCM) erstrecken, wobei jeder Ausschnitt in eine kreisförmige Ausnehmung (CH) an wenigstens einem seiner Enden mündet, wobei die Längsausschnitte (LC) Verformungen der biegsamen gedruckten Schaltung zulassen, wobei die ersten, mit dem Aufnahmegestell verbundenen Anschlußmittel mit Kontakten mit niedriger Steckkraft ausgestattet sind, um einer großen Zahl von Anschluß- und Löseoperationen zu genügen, wobei die Kontakte mit genormten Anschlüssen zusammenwirken.

2. Anschlußsystem (CS) für eine abnehmbare Einrichtung nach Anspruch 1, dadurch gekennzeichnet, daß einerseits das zur Verbindung mit den ersten Anschlußmitteln bestimmte Ende der biegsamen gedruckten Schaltung (ECM) in Querrichtung und wenigstens an einer seiner beiden Seiten mit einem schmalen Band (ES1,...) aus einem starren Material überdeckt ist, das mit kalibrierten, metallisierten Löchern (GMH) versehen ist, die über den Anschlußpillen (CPH) der leitfähigen Zeilen (L) der biegsamen gedruckten Schaltung (ECM) liegen, und andererseits die ersten Anschlußmittel (FCM) aus einem genormten Verbinder gebildet sind, dessen Kontakte zum Anschluß an das Aufnahmegestell geschmiert sind, und dessen Anschlüsse an die biegsame gedruckte Schaltung Anschlüsse sind, die mit Kraft in die kalibrierten Löcher eingeführt sind, wobei sie die Pillen (CPH) der biegsamen gedruckten Schaltung (ECM) einklemmen.

3. Anschlußsystem (CS) für eine abnehmbare Einrichtung nach Anspruch 1, dadurch gekennzeichnet, daß die ersten Anschlußmittel (FCM) aus einem genormten Verbinder gebildet sind, dessen Kontakte Kolbenkontakte sind, und dessen Anschlüsse an die biegsame gedruckte Schaltung Anschlüsse sind, die an die Pillen (CPH) der biegsamen gedruckten Schaltung (ECM) gelötet sind.

4. Anschlußsystem (CS) für eine abnehmbare Einrichtung nach Anspruch 1, dadurch gekennzeichnet, daß einerseits das zur Verbindung mit den ersten Anschlußmitteln (FCM) bestimmte Ende der biegsamen gedruckten Schaltung in Querrichtung und wenigstens an einer seiner beiden Seiten mit einem schmalen Band (ES1,...) aus einem starren Material überdeckt ist, das mit kalibrierten, metallisierten Löchern (GMH) versehen ist, die über die Anschlußpillen (CPH) der leitfähigen Zeilen (L) der biegsamen gedruckten Schaltung (ECM) gelegt sind, und andererseits die ersten Anschlußmittel (FCM) aus einem genormten Verbinder gebildet sind, dessen Kontakte Kolbenkontakte sind, und dessen Anschlüsse an die biegsame gedruckte Schaltung Anschlüsse sind, die mit Kraft in die kalibrierten Löcher (GMH) eingeführt sind, wobei sie die Pillen (CPH) der biegsamen gedruckten Schaltung (ECM) einklemmen.

5. Anschlußsystem (CS) für eine abnehmbare Einrichtung nach Anspruch 2, 3 oder 4, dadurch gekennzeichnet, daß die biegsame gedruckte Schaltung (ECM) mit Mitteln zur Entkopplung der leitfähigen Zeilen versehen ist, die der Signalübertragung zugeordnet sind, wobei die der Signalübertragung zugeordneten Zeilen (LS) von leitfähigen Doppelzeilen (LG) umrandet sind, die elektrisch mit Masse verbunden sind.

6. Anschlußsystem (CS) für eine abnehmbare Einrichtung nach einem der vorhergehenden Ansprüche, dadurch gekennzeichnet, daß an einem Ende der biegsamen gedruckten Schaltung Anschlußgabeln (BC), die leitfähige Zeilen (L) abschließen, zweite Anschlußmittel (SCM) bilden, wobei die Anschlußgabeln (BC) durch Falzung der Schaltung innerhalb einer nichtisolierten Zone (NIA) längs einer Achse (XX') erhalten sind, die durch die Mitten von Langlöchern (OH) verläuft, die in den leitfähigen Zeilen (L) mit geeigneter Breite vorgesehen sind.

7. Anschlußsystem (CS) für eine abnehmbare Einrichtung nach Anspruch 6, dadurch gekennzeichnet, daß zur Vereinfachung der Falzung beim Formen der Schaltung eine Dickenverringerung (TR) der leitfähigen Zeilen (L) längs der Achse (XX') vorgesehen ist, die durch die Mitten der Länglöcher (OH) verläuft.

8. Anschlußsystem (CS) für eine abnehmbare Einrichtung nach einem der vorhergehenden Ansprüche, dadurch gekennzeichnet, daß es Abschirmmittel aufweist, die durch Falzung einer mit Masse verbundenen und isolierten, leitfähigen Lage (SM) erhalten sind, die ein Ende der biegsamen gedruckten Schaltung (ECM) verlängert.

## Claims

1. Connection system (CS) for removable equipment in a housing of a reception rack for a plurality of pieces of electronic equipment, comprising first connection means (FCM) for electrically connecting the removable equipment to the reception rack, second connection means (SCM1, SCM2, ...) inside the removable equipment, connected to the first connection means via electrical connection means (ECM) constituted by a flexible printed circuit comprising a plurality of longitudinal cutouts (LC) which extend from the first connection means (FCM) to the second connection means (SCM), each cut-out ending in a circular hole (ICH) at at least one of its ends, the longitudinal cut-outs (LC) permitting deflections of said flexible printed circuit, the first connection means connected to the reception rack being equipped with low-insertion-force contacts in order to satisfy a large number of connection and disconnection operations, said contacts co-operating with standard connections.

2. Connection system (CS) for removable equipment according to Claim 1, characterised in that, on the one hand, the end of the flexible printed circuit (ECM) intended to be connected to the first connection means is, transversely and at least on one of its two faces, covered with a narrow strip of rigid material (ES1,...) provided with gauged metallised holes (GMH) superimposed over the connection pads (CPH) of the conductor lines (L) of the flexible printed circuit (ECM) and, on the other hand, the first connection means (FCM) are constituted by a standard connector, in which the contacts for connection to the reception rack are lubricated and the connections with the flexible printed circuit are connections force-fitted into the gauged holes encircling the pads (CPH) of the flexible printed circuit (ECM).

3. Connection system (CS) for removable equipment according to Claim 1, characterised in that the first connection means (FCM) are constituted by a standard connector, in which the contacts are gun-type contacts and the connections with the flexible printed circuit are connections soldered to the pads (CPH) of the flexible printed circuit (ECM).

4. Connection system (CS) for removable equipment according to Claim 1, characterised in that, on the one hand, the end of the flexible printed circuit intended to be connected to the first connection means (FCM) is, transversely and at least on one of its two faces, covered with a narrow strip of rigid material (ES1,...) provided with gauged metallised holes (GMH) superimposed over the connection pads (CPH) of the conductor lines (L) of the flexible printed circuit (ECM) and, on the other hand, the first connection means (FCM) are constituted by a standard connector, in which the contacts are gun-type contacts and the connections with the flexible circuit are connections force-fitted into the gauged holes (GMH) encircling the pads (CPH) of the flexible printed circuit (ECM).

5. Connection system (CS) for removable equipment according to Claim 2, 3 or 4, characterised in that the flexible printed circuit (ECM) is provided with means for uncoupling the conductor lines assigned to the transmission of signals, said lines (LS) assigned to the transmission of signals being bordered by dual conductor lines (LG) electrically connected to earth.

6. Connection system (CS) for removable equipment according to one of the preceding claims. characterised in that, at one end of the flexible printed circuit, connection brackets (BC) at the end of the conductor lines (L) constitute second connection means (SCM), said connection brackets (BC) being obtained by bending the circuit within a non-insulated area (NIA), along an axis (XX') passing through the centres of oblong holes (OH) made in said conductor lines (L), of an appropriate width.

7. Connection system (CS) for removable equipment according to Claim 6, characterised in that, to facilitate bending when the circuit is shaped, a thickness reduction (TR) is provided in the conductor lines (L) along the axis (XX') passing through the centres of the oblong holes (OH).

8. Connection system (CS) for removable equipment according to one of the preceding claims, characterised in that it comprises screening means obtained by folding a conductive sheet (SM) connected to earth and insulated, extending one end of the flexible printed circuit (ECM).
